# FASCICULE DE BREVET EUROPEEN

(11) **EP 0 742 620 B1**
(45) Date de publication et mention de la délivrance du brevet: **14.06.2000**
(21) Numéro de dépôt: 96400907.0
(22) Date de dépôt: 26.04.1996
(51) Int. Cl.: H01S 5/10, G02B 6/12

(54) **Laser à semiconducteurs**
Halbleiterlaser
Semi-conductor lasers

(30) Priorité: 12.05.1995 FR 9505660
(43) Date de publication de la demande: 13.11.1996
(73) Titulaire: THOMSON-CSF, 75008 Paris (FR)
(72) Inventeur: Houdre, Romuald, 92402 Courbevoie Cedex (FR); Weisbuch, Claude, 92402 Courbevoie Cedex (FR); Berger, Vincent, 92402 Courbevoie Cedex (FR)

(56) Documents cités:
- WO-A-94/16345
- US-A- 5 365 541
- PATENT ABSTRACTS OF JAPAN vol. 012, no. 244 (E-631), 9 Juillet 1988 & JP-A-63 032983 (MITSUBISHI ELECTRIC CORP), 12 Février 1988,
- ELECTRONICS LETTERS, vol. 30, no. 17, 18 Août 1994, pages 1444-1446, XP000476049 KRAUSS T ET AL: "FABRICATION OF 2-D PHOTONIC BANDGAP STRUCTURES IN GAAS/ALGAAS"
- PHYSICAL REVIEW LETTERS, vol. 67, no. 17, 21 Octobre 1991, pages 2295-2298, XP000363623 YABLONOVITCH E ET AL: "PHOTONIC BAND STRUCTURE: THE FACE-CENTERED-CUBIC CASE EMPLOYING NONSPHERICAL ATOMS"
- PATENT ABSTRACTS OF JAPAN vol. 012, no. 221 (E-625), 23 Juin 1988 & JP-A-63 016690 (FUJITSU LTD), 23 Janvier 1988,

## Description

L'invention concerne un laser à semiconducteurs et plus particulièrement un laser à confinement optique latéral réalisé par un matériau présentant une structure présentant une bande interdite photonique.

L'invention est applicable particulièrement à la réalisation de matrices lasers à semiconducteurs émettant par la surface. Elle permet alors une technologie de réalisation plus simple que celle actuellement utilisée et présentant une plus grande efficacité.

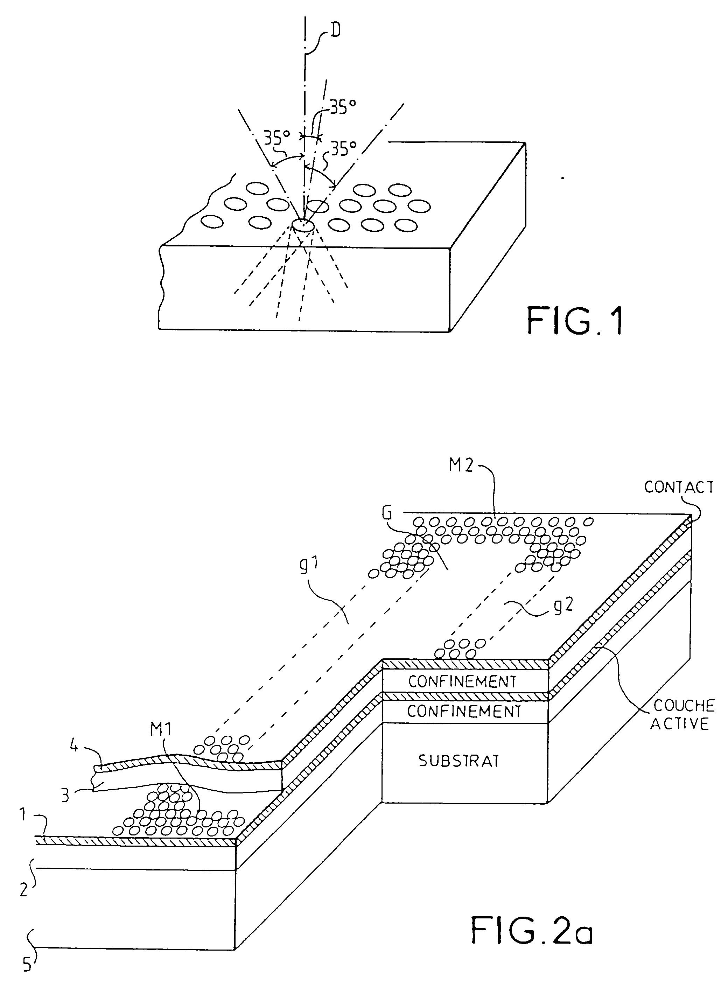

Les matériaux à bande interdite photonique (en anglais : Photonic Bandgap) sont apparus récemment dans la littérature : ce sont des matériaux dans lesquels la fonction diélectrique est structurée de manière périodique, ceci dans plusieurs dimensions, d'où leur appellation également de cristaux photoniques. On trouvera dans l'article "Photonic Crystals" de E. YABLONOVITCH publié dans Journal of Modern Optics, 1994, vol 41, n° 2, pp. 173-194 une description d'un tel matériau. Selon la technologie décrite dans cet article, un tel matériau peut être réalisé en perçant des trous dans un substrat selon plusieurs directions (voir pages 183 et 186 de cet article). Ainsi comme représenté en figure 1, à la surface d'un substrat, on perce des séries de trois trous dont les axes passent par le même point. Ces trois trous forment chacun un angle de 35° par rapport à la normale au plan du substrat et forment des angles égaux entre eux (voir figure 1). Le reste du substrat qui reste entre les trous peut alors être assimilé à une structure cristalline hexagonale. Il est évident qu'il est possible de réaliser d'autres types de structures de matériau à bande interdite photonique, présentant des motifs différents.

WO-A- 94 16 345 décrit un circuit optique dans lequel un guide d'onde est formé par un matériau à bande interdite photonique. Le guide d'onde relie des composants optiques, par exemple un laser et un détecteur. Ledit matériau assure alors l'isolation des composants entre eux ainsi qu'avec d'autres composants intégrés dans le substrat.

La fonction d'une structure de matériau à bande interdite photonique permet de réaliser des miroirs diélectriques.

L'invention concerne la réalisation d'un laser mettant en jeu des matériaux à bande interdite photonique.

L'invention concerne donc un laser à semiconducteurs comprenant au moins une couche active enserrée entre deux couches de confinement dopées P et N pour constituer une jonction PN, caractérisé en ce qu'il comporte dans au moins l'une des couches de confinement et/ou la couche active, des trous disposés de part et d'autre de la cavité de façon à réaliser le long des parois latérales de la cavité et aux extrémités de la cavité des structures de matériau à bande interdite photonique.

Les différents objets et caractéristiques de l'invention apparaîtront plus clairement dans la description qui va suivre et dans les figures annexées qui représentent:
- la figure 1, un exemple de réalisation de matériau à bande interdite photonique ;
- la figure 2a, un exemple de laser selon l'invention ;
- la figure 2b, une variante du laser de la figure 2a permettant une émission par la surface ;
- la figure 2c, une vue en coupe des lasers des figures 2a et 2c ;
- les figures 3a et 3b, un ensemble de lasers.

L'invention concerne le confinement optique transversal d'un laser à semiconducteur à l'aide d'un matériau à bande interdite photonique. Un schéma de principe d'une telle structure est donné sur la figure 2a.

Un substrat 5 comporte sur une face principale un empilement des couches suivantes :
- une première couche de confinement 2 dopée P ;
- une couche active laser 1 ;
- une deuxième couche de confinement 3 dopée N ;
- une couche de contact.

A partir de la face supérieure de la structure des trous ont été percés de façon à réaliser un matériau à bande photonique de part et d'autre du laser (zones g1 et g2) et en bouts de lasers (miroirs M1 et M2).

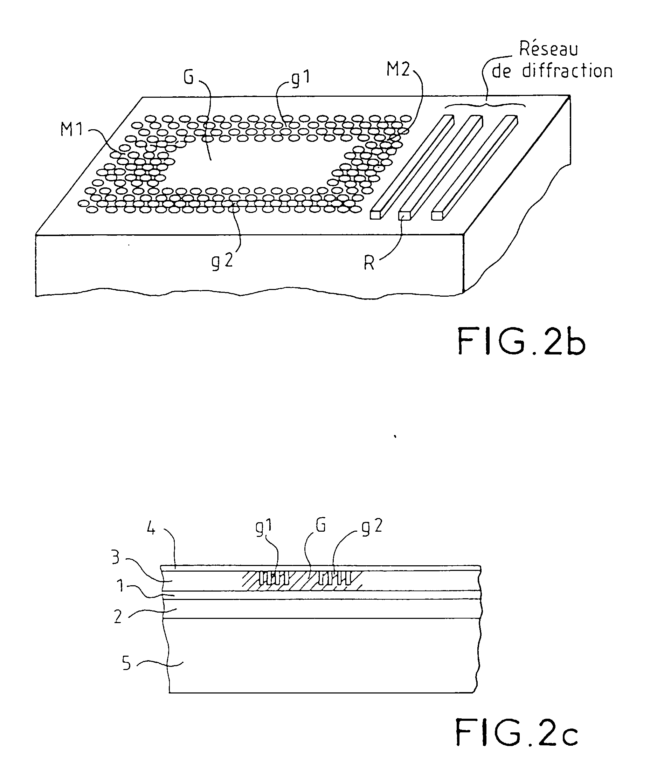

Un matériau à bande interdite photonique à deux dimensions suffit, car le mode optique est confiné dans la troisième direction (l'épaisseur du laser) par la structure multicouche réalisée lors de la croissance du laser, comme dans un laser classique. Le coefficient de réflexion des miroirs M1, M2 placé aux extrémités du laser peut être accordé à volonté en changeant le nombre de périodes du matériau à bande interdite photonique. Ce nombre n'est pas nécessairement entier, le miroir pouvant s'interrompre sur une fraction de période du cristal photonique. Dans l'exemple de la figure 2, le laser émet sa puissance vers la droite, car le miroir M2 de droite a été conçu de manière à ce qu'il soit moins réfléchissant que le miroir M1 de gauche, car il contient un nombre de périodes inférieur.

Le matériau à bande interdite photonique situé de part et d'autre du laser dans les zones g1 et g2 détermine le guidage latéral du guide et réalise un ruban de guidage G dans le guide.

La figure 2b représente une variante de réalisation de l'invention concernant un laser à émission par la surface.

A la sortie du laser, du côté du miroir M2 la lumière est orientée vers la surface de la structure à l'aide d'un réseau de diffraction R.

La figure 2c représente en coupe le laser des figures 2a et 2b.

Les trous qui réalisent le matériau à bande interdite photonique des zones de guidage g1, g2 et des miroirs M1, M2 peuvent avoir une section droite de forme carrée, circulaire, polygonale, etc...

En ce qui concerne la profondeur de ces trous, plus elle est importante plus l'efficacité de guidage (ou de réflexion) de la lumière est importante. Lorsque les trous traversent la couche active 1, l'efficacité est maximale. Quoi qu'il en soit, on choisira la profondeur des trous de façon que la distance des fonds des trous à la couche active soit inférieure à la longueur d'onde du laser (soit inférieure à quelques dixièmes de micromètre.

De préférence, les trous sont vides de tout matériau de façon à assurer un contraste d'indice élevé entre le matériau à bande interdite photonique et le matériau situé de part et d'autre.

Les différents trous ont une disposition régulière de façon à former un réseau régulier. Les mailles de ce réseau ont donc une forme régulière qui peut être de forme carrée, hexagonale notamment.

Les trous et les différentes mailles auront des dimensions telles que les trous remplissent environ 70 % de la surface (plus généralement de 10 à 90 %). Par ailleurs, la distance entre trous est telle que a = 0,2 à 0,5 λ (par exemple a = 0,36 λ et taux de remplissage 70 %) (a étant la distance entre trous et λ la longueur d'onde) (voir Solid State Electronic 37, 1341-1994).

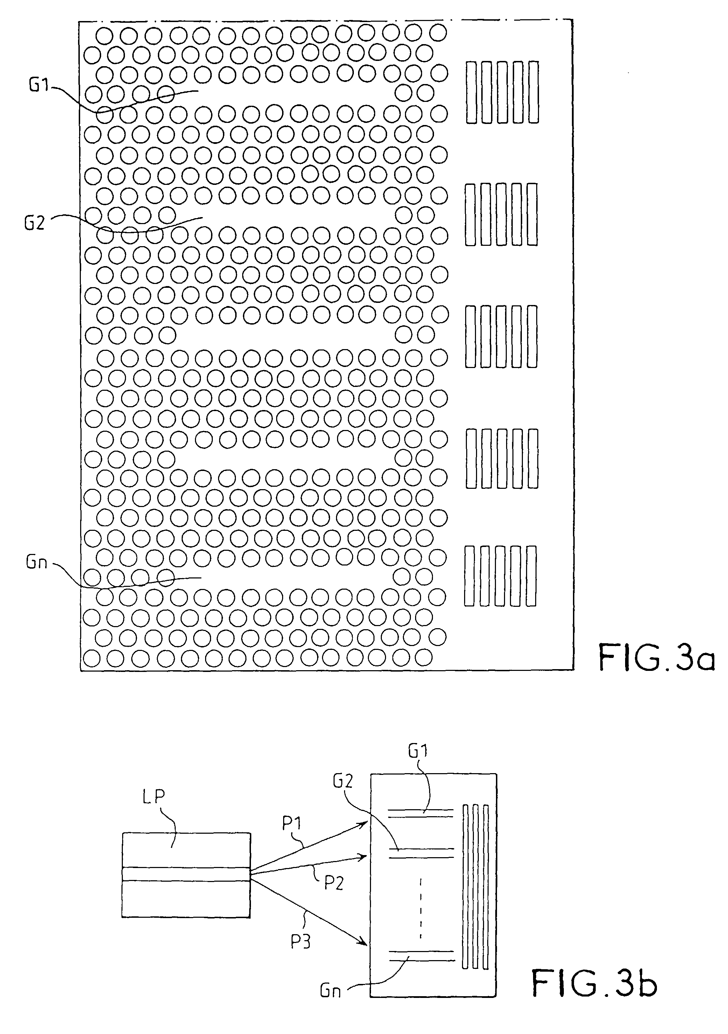

Les figures 3a et 3b représentent un ensemble de lasers G1, G2, ... G3 réalisés sur un même substrat avec les réseaux de diffractions R1, R2, ... R3. Ces réseaux peuvent d'ailleurs être réalisés en un seul réseau (voir figure 3b).

La figure 3b représente schématiquement les lasers G1, G2, ... Gn pompés par un laser LP émettant vers chacun d'eux un faisceau de pompe P1, P2, ... P3.

L'isolation électrique des lasers peut être éventuellement réalisée classiquement par une technique d'implantation de protons sur les parties de la plaque qui ne nécessitent pas de gain optique, donc pas d'injection électrique.

On peut éventuellement éviter la recombinaison de porteurs sur les défauts de surface introduits par la gravure des matériaux à bande interdite photonique en réalisant une interdiffusion assistée par atomes étrangers (le Bore par exemple) ; pour cela une épaisseur faible d'interdiffusion suffit (par exemple 5,0 à 10,0 mm; 50 à 100 Å).

On peut également prévoir un couplage optique entre les différents lasers pour qu'ils émettent tous en phase G1, G2, ... Gn. Pour cela, la largeur de chaque bande séparant deux lasers est dimensionnée pour permettre ce couplage. Par exemple, elle comprendra 1 à 5 mailles de matériau à bande interdite photonique. Ceci constitue un moyen pour que tous les lasers émettent en phase.

L'invention présente les avantages suivants :
- Un premier avantage réside dans la meilleure qualité des interfaces optiques réalisées par les matériaux à bande interdite photonique. Dans un tel matériau, les défauts de surface optique ne couplent le mode optique du laser qu'à des modes évanescents dans le matériau à bande interdite photonique, et donc pas à l'extérieur. Les matériaux à bande interdite photonique permettent donc la réalisation de surfaces optiques parfaites, sans pertes indésirables vers des modes extérieurs. Ces miroirs sont notamment bien meilleurs que les miroirs réalisés habituellement dans des technologiques pleines plaques, par exemple par gravure ionique réactive, qui présentent beaucoup de défauts.
- Un deuxième avantage apporté par cette invention réside dans l'inhibition de l'émission spontanée réalisée par le matériau à bande interdite photonique. Si l'on dispose en dessous et dessus de la structure de miroirs plans classiques (métalliques ou multicouches), le contrôle de l'émission spontanée est réalisé sur l'ensemble des modes du champ électromagnétique, sur les trois dimensions. On améliore ainsi le rendement des lasers, ouvrant également la possibilité de faire baisser leur seuil notamment pour les petites cavités donc pour les lasers de petites puissance.

## Revendications

1. Laser à semiconducteurs comprenant au moins une couche active (1) enserrée entre deux couches de confinement (2, 3) dopées P et N pour constituer une jonction PN, caractérisé en ce qu'il comporte dans au moins l'une des couches de confinement et/ou la couche active, des trous disposés de part et d'autre de la cavité de façon à réaliser le long des parois latérales (g1, g2) de la cavité (G) et aux extrémités (M1, M2) de la cavité (G) des structures de matériau à bande interdite photonique.

2. Laser à semiconducteur selon la revendication 1, caractérisé en ce qu'il comporte un réseau de diffraction (R) disposé perpendiculairement à la direction longitudinale de la cavité, ce réseau étant disposé du côté d'une des extrémité de sortie (M2) du laser.

3. Laser à semiconducteur selon la revendication 1, caractérisé en ce que la profondeur des trous dans la couche de confinement est telle que la distance des fonds des trous à la couche active est inférieure à la longueur d'onde de fonctionnement du laser.

4. Laser à semiconducteur selon la revendication 1, caractérisé en ce que le nombre de périodes de trous est inférieur à une extrémité (M2) par rapport à l'autre extrémité (M1).

5. Laser à semiconducteur selon la revendication 1, caractérisé en ce que les trous et les différentes mailles du matériau à bande interdite photonique ont des dimensions telles que les trous remplissent 10 à 90 % de la surface du matériau.

6. Laser à semiconducteur selon la revendication 5, caractérisé en ce que les trous remplissent environ 70 % de la surface du matériau.

7. Laser à semiconducteur selon la revendication 5, caractérisé en ce que la distance entre trous est comprise sensiblement entre 0,2 λ et 0,5 λ, λ étant la longueur d'onde de fonctionnement du laser.

8. Laser à semiconducteur selon la revendication 2, caractérisé en ce qu'il comporte plusieurs lasers (G1, ... Gn) disposés en parallèle.

9. Laser à semiconducteur selon la revendication 8, caractérisé en ce qu'il comporte un réseau de diffraction commun à tous les lasers (G1, ... Gn).

10. Laser à semiconducteur selon la revendication 8, caractérisé en ce que la largeur de matériau à bande interdite photonique séparant deux lasers correspond à sensiblement 1 à 5 mailles du réseau du matériau à bande interdite photonique pour permettre un couplage entre laser.

11. Laser à semiconducteur selon la revendication 1, caractérisé en ce que les trous sont vides de matériau.

## Patentansprüche

1. Halbleiterlaser mit wenigstens einer aktiven Schicht (1), die zwischen zwei Begrenzungsschichten (2, 3) liegt, von denen eine p- und eine n-dotiert ist, so daß ein PN-Übergang gebildet wird, dadurch gekennzeichnet, daß in wenigstens einer der Begrenzungsschichten und/oder der aktiven Schicht auf beiden Seiten des Hohlraums (G) Löcher in der Weise angeordnet sind, daß längs der Seitenwände (gl, g2) des Hohlraums (G) und an den Enden (M1, M2) des Hohlraums (G) Strukturen aus einem Material mit einer photonischen Bandlücke gebildet sind.

2. Halbleiterlaser nach Anspruch 1, dadurch gekennzeichnet, daß er ein Beugungsgitter (R) umfaßt, das senkrecht zur Längsrichtung des Hohlraums liegt, wobei das Gitter an der Seite einer der Ausgangsenden (M2) des Lasers liegt.

3. Halbleiterlaser nach Anspruch 1, dadurch gekennzeichnet, daß die Tiefe der Löcher in der Begrenzungsschicht so gewählt ist, daß der Abstand der Böden der Löcher zu der aktiven Schicht kleiner als die Wellenlänge ist, bei der der Laser arbeitet.

4. Halbleiterlaser nach Anspruch 1, dadurch gekennzeichnet, daß die Periodenzahl der Löcher an einem Ende (M2) kleiner ist als am anderen Ende (M1).

5. Halbleiterlaser nach Anspruch 1, dadurch gekennzeichnet, daß die Löcher und die verschiedenen Maschen des Materials mit photonischer Bandlücke so bemessen sind, daß die Löcher 10 bis 90% der Oberfläche des Materials füllen.

6. Halbleiterlaser nach Anspruch 5, dadurch gekennzeichnet, daß die Löcher ungefähr 70% der Oberfläche des Materials füllen.

7. Halbleiterlaser nach Anspruch 5, dadurch gekennzeichnet, daß der Abstand zwischen den Löchern ungefähr zwischen 0,2 λ und 0,5 λ liegt, wobei λ die Wellenlänge ist, bei der der Laser arbeitet.

8. Halbleiterlaser nach Anspruch 2, dadurch gekennzeichnet, daß er mehrere Laser (G1, ..., Gn) umfaßt, die parallel angeordnet sind.

9. Halbleiterlaser nach Anspruch 8, dadurch gekennzeichnet, daß die Laser (G1,...Gn) alle ein gemeinsames Beugungsgitter besitzen.

10. Halbleiterlaser nach Anspruch 8, dadurch gekennzeichnet, daß die Breite des eine photonische Bandlücke aufweisenden Materials, das zwei Laser trennt, ungefähr 1-5 Maschen des Netzes des eine photonische Bandlücke aufweisenden Materials beträgt, um eine Kopplung zwischen Lasern zu ermöglichen.

11. Halbleiterlaser nach Anspruch 1, dadurch gekennzeichnet, daß die Löcher frei von Material sind.

## Claims

1. Semiconductor laser comprising at least one active layer (1) sandwiched between two confinement layers (2, 3), one p-doped and the other n-doped, in order to form a pn junction, characterized in that it comprises, in at least one of the confinement layers and/or the active layer, holes located on each side of the cavity so as to produce structures of photonic band-gap material along the side walls (g1, g2) of the cavity (G) and at the ends (M1, M2) of the cavity (G).

2. Semiconductor laser according to Claim 1, characterized in that it includes a diffraction grating (R) arranged so as to be perpendicular to the longitudinal direction of the cavity, this grating being located on the same side as one of the output ends (M2) of the laser.

3. Semiconductor laser according to Claim 1, characterized in that the depth of the holes in the confinement layer is such that the distance from the bottom of the holes to the active layer is less than the operating wavelength of the laser.

4. Semiconductor laser according to Claim 1, characterized in that the number of periods of holes is smaller at one end (M2) than at the other end (M1).

5. Semiconductor laser according to Claim 1, characterized in that the holes and the various mesh cells of the photonic band-gap material have dimensions such that the holes occupy 10 to 90% of the surface of the material.

6. Semiconductor laser according to Claim 5, characterized in that the holes occupy about 70% of the surface of the material.

7. Semiconductor laser according to Claim 5, characterized in that the distance between holes is approximately between 0.2 λ and 0.5 λ, λ being the operating wavelength of the laser.

8. Semiconductor laser according to Claim 2, characterized in that it comprises several lasers (G1, .. Gn) arranged in parallel.

9. Semiconductor laser according to Claim 8, characterized in that it includes a diffraction grating common to all the lasers(G1,.. Gn)

10. Semiconductor laser according to Claim 8, characterized in that the width of photonic band-gap material separating two lasers corresponds to approximately 1 to 5 mesh cells of the lattice of the photonic band-gap material in order to allow coupling between lasers.

11. Semiconductor laser according to Claim 1, characterized in that the holes are empty of material.
